# EUROPÄISCHE PATENTSCHRIFT

(11) **EP 1 903 123 B1**
(45) Veröffentlichungstag und Bekanntmachung des Hinweises auf die Patenterteilung: **22.02.2012**
(21) Anmeldenummer: 07024025.4
(22) Anmeldetag: 19.11.2004
(51) Int. Cl.: C23C 14/34

(54) **Trägerplatte mit einer darauf aufgesetzten gekühlten Rückenplatte**
Mounting plate with a cooled backing plate set on top
Plaque de support dotée d'une plaque envers refroidie et montée sur celle-ci

(43) Veröffentlichungstag der Anmeldung: 26.03.2008
(62) Teilanmeldung aus: 04027573.7
(73) Patentinhaber: Applied Materials GmbH & Co. KG, 63755 Alzenau (DE)
(72) Erfinder: Krempel-Hesse, Jörg, 63683 Eckartsborn (DE); Schüßler, Uwe, 63743 Aschaffenburg (DE); Jischke, Andreas, 63796 Kahl (DE); Wolf, Hans, 63526 Erlensee (DE)
(74) Vertreter: Schickedanz, Willi

(56) Entgegenhaltungen:
- DE-A1- 19 916 938
- FR-A- 2 573 441

## Beschreibung

Die Erfindung bezieht sich auf eine Trägerplatte mit einer darauf aufgesetzten gekühlten Rückenplatte für ein Sputtertarget, auf deren Vorderseite ein zu sputterndes Material anbringbar ist und auf deren Rückseite Mittel zur Kühlung der Rückenplatte vorhanden sind, die aus einem zwischen einem Kühlmitteleinlass und einem Kühlmittelauslass verlaufenden Kühlkanal bestehen, wobei die Trägerplatte mit den Kühlmittelein- und -auslässen fluchtende Kühlmittelbohrungen aufweist und die Übergänge zwischen den Kühlmittelbohrungen und den Kühlmittelein-und -auslässen gedichtet sind.

Eine derartige Rückenplatte ist in der US 6,494,999 B1 beschrieben. Demnach ist die Rückenplatte zweiteilig ausgeführt. Eine erste Platte dient als Halter für das zu sputternde Material, das in Form von Kacheln dort angebracht wird. Eine unterhalb dieser ersten Platte angebrachte zweite Platte ist mit Kühlkanälen versehen, um die im Betrieb an der ersten Platte entstehende Wärme abführen zu können.

Die aus den zwei Einzelplatten bestehende Rückenplatte weist durch die zweiteilige Ausführung eine gewisse Dicke auf, was insofern nachteilig ist, weil sich hinter der Rückenplatte üblicherweise eine Magnetanordnung befindet, deren Feldlinien durch die Rückenplatte hindurch greifen müssen, damit sich vor der Vorderseite ein Magnetfeld ausbildet, das der Erhöhung der Sputterrate dient.

Es sind außerdem Anordnungen bekannt, bei denen die Kühlplatte auf einer Trägerplatte aufgebracht wird, die in die Öffnung eines Vakuumkessels eingesetzt wird, wobei sich die Magnetanordnung außerhalb des Vakuumkessels befindet. Die Feldlinien müssen daher nicht nur die Rückenplatte, sondern auch die Trägerplatte durchgreifen. Es kommt daher entscheidend darauf an, dass vor allem die Rückenplatte nicht zu dick ausgeführt ist, so dass auch bei nicht allzu starken Magneten ein ausreichendes Magnetfeld vor der Rückenplatte aufgebaut werden kann. Auf der anderen Seite darf die Rückenplatte nicht zu dünn ausgeführt werden, da sie als Halter für das zu sputternde Material dient, das in der Regel in Form von Kacheln auf der Vorderseite angebracht wird. Die Platte muss daher eine ausreichende Steifigkeit aufweisen. Dies gilt insbesondere dann, wenn die Rückenplatte nicht vollflächig auf der Trägerplatte aufliegt, sondern lediglich randseitig auf Tragstegen liegt und den Raum zwischen diesen frei tragend überspannen soll.

Die Rückenplatten, die zuvor auf ihrer Vorderseite mit den Kacheln versehen worden sind, werden in einem Ensemble auf der Innenseite einer Trägerplatte befestigt, die als Ganzes in die Öffnung eines Vakuumkessels eingesetzt wird, so dass sich die Rückenplatte innerhalb des Kessels befindet, wobei die Rückenplatte auf Tragstegen der Trägerplatte aufliegt, wobei die Kühlmittelein- bzw. - auslässe auf diesen Tragstegen liegen. Zum Zuführen von Kühlmittel zur Trägerplatte führen durch die Tragstege Kühlmittelbohrungen von der Außen- zur Innenseite der Trägerplatte zu dem Kühlmitteleinlass und dem Kühlmittelauslass. Ein einfacher Dichtring, wie er in der US PS 6,494,999 beschrieben ist, kann nicht vollständig verhindern, dass Kühlmittelflüssigkeit ins Vakuum gelangt und dieses mit Fremdstoffen belastet.

Die Erfindung beruht auf dem Problem, eine solche Belastung zu vermeiden, so dass die Pumpleistung nicht zu stark gefordert ist.

Zur Lösung des Problems, wird eine Dichtanordnung vorgesehen, die erfindungsgemäß aus zwei radial beabstandeten Dichtungsringen besteht, wobei der Zwischenraum zwischen den Dichtungsringen über eine Entlüftungsbohrung mit der Außenseite der Rückenplatte, also mit der Atmosphäre in Verbindung steht. Der innenliegende Dichtungsring isoliert somit den Zu- bzw. Ablauf des Kühlmittels gegenüber der Atmosphäre, während der außen liegende Dichtungsring eine Trennung zwischen der Atmosphäre und dem Vakuum im Inneren des Kessels bewirkt. Kühlmittelflüssigkeit, die den ersten Dichtungsring überwindet, gelangt somit nicht gleich ins Vakuum, sondern in einen belüfteten Bereich und kann dort verdunsten, was die Belastung des Vakuums mit Fremdstoffen reduziert, so dass die Pumpleistung nicht zu stark gefordert ist.

Vorzugsweise befinden sich die Dichtungsringe in der Trägerplatte, obwohl derselbe Zweck auch erreicht würde, wenn sie sich in der Rückenplatte befänden. Dies hätte aber den Nachteil, dass sie von der Wärme, die beim Auflöten der Kacheln auf die Vorderseite der Rückenplatte entsteht, Schaden nehmen könnten.

Eine weitere Ausgestaltung der Erfindung besteht darin, dass in der Rückenplatte wenigstens eine zur Rückenseite der Rückenplatte offene Nut zwischen einem Kühlmitteleinlass und einem Kühlmittelauslass verläuft, dass die Nut von einem äußeren Rahmen der Rückenplatte umgeben ist und innerhalb des Rahmens wenigstens ein vom Rahmen entfernter Steg verläuft, der zwei Nutabschnitte voneinander trennt, und dass die offene Seite der Nut zur Bildung eines im Querschnitt geschlossenen Kühlkanals durch eine Verschlussplatine verschlossen ist, die mit dem Rahmen und dem Steg verschweißt ist und in der Löcher vorhanden sind, die den Kühlmitteleinlass und den Kühlmittelauslass bilden.

Der Effekt dieser Maßnahme besteht darin, dass die Kühlmittelkanäle in der Rückenplatte ausgeführt sind und diese somit gleichzeitig als Kühlplatte dient, so dass insgesamt eine geringe Dicke realisiert wird, weil auf eine zweiteilige Ausführung - wie oben zum Stand der Technik beschrieben - verzichtet werden kann. Die notwendige Steifigkeit der Rückenplatte erhält man, indem eine die Kanäle verschließende, relativ flache Verschlussplatine nicht nur mit ihrem Rand am Rahmen der Rückenplatte befestigt ist, sondern in ihrer Fläche auch mit einem oder mehreren Stegen, die verschiedene Abschnitte der Nut voneinander trennen. Dadurch ergeben sich zusätzlich zur Randbefestigung mehrere über die Rückenplatte verteilte Befestigungslinien, was insgesamt zu deren Aussteifung führt.

Da die Schweißnaht mit den Stegen von der Verschlussplatine selbst verdeckt ist, muss ein Schweißverfahren zum Einsatz kommen, bei dem auch verdeckte Schweißnähte gesetzt werden können. Ein sogenanntes ElektronenstrahlSchweißen (ES-Schweißen) hat sich für diese Aufgabe bewährt.

Um eine glatte Rückenseite der Rückenplatte zu erhalten, besitzt der Innenrand des Rahmens einen umlaufenden Absatz zur Aufnahme der Verschlussplatine. Die Höhe des Absatzes entspricht der Dicke der Verschlussplatine, so dass die auf dem Absatz aufliegende Verschlussplatine bündig mit dem nicht abgesetzten Teil des Rahmens abschließt und somit insgesamt eine glatte Rückenfläche erreicht wird.

Zur Versorgung der Kühlkanäle mit einer Kühlflüssigkeit sind im Rahmen wenigstens zwei zur Rückseite hin offene Taschen vorhanden, die von der Verschlussplatine überdeckt sind. In dem Bereich der Verschlussplatine, die über den Taschen liegt, sind Löcher ausgebildet, die zum Ein- bzw. Austritt eines Kühlmittels dienen. Dazu wird die Rückenplatte so auf die oben schon erwähnte Trägerplatte gelegt, dass die Löcher mit entsprechenden Kühlmittelbohrungen in der Trägerplatte fluchten.

Wie ebenfalls schon erwähnt, soll die Rückenplatte nicht flächig auf der Trägerplatte aufliegen, sondern auf dort vorhandenen Tragstegen. Die Taschen befinden sich daher im nicht abgesetzten Teil des Rahmens, wozu die Verschlussplatine Ohren aufweist, die über den Taschen liegen, und in denen die Löcher zum Ein- und Austritt eines Kühlmittels vorhanden sind.

Wie schon erwähnt, dient die Rückenplatte zum Anbringen von Kacheln aus zu sputterndem Material in einer Sputteranlage. Die hinter der Rückenplatte bzw. Trägerplatte angebrachten Magnete erzeugen eine Erosionszone in Form von ovalen Ringen, die auch als Race Tracks bezeichnet werden. In den Kreisabschnitten eines Ovals ist in der Regel eine erhöhte Sputterrate zu verzeichnen, so dass hier bevorzugt dickere Endkacheln angebracht werden. Um trotzdem zumindest eine flache obere Ebene der Kacheln zu erhalten, wären die Endkacheln vertieft an der Rückenplatte anzubringen. Dazu besitzt die Vorderseite der Rückenplatte an einem Endbereich einen über die gesamte Breite der Rückenplatte sich erstreckenden, vertieften Abschnitt. Hier können dickere Endkacheln eingesetzt werden, deren Oberfläche mit den übrigen Kacheln bündig abschließt.

Da die Kacheln die Rückenplatte nicht über deren gesamte Breite abdecken, bleibt der Rand der Rückenplatte frei und bildet einen Rahmen für die Kacheln. Um auch im Randbereich eine durchgehend ebene Oberfläche zu haben, wird auf den Rand des vertieften Bereichs ein U-förmiges Füllblech angesetzt, dessen Dicke der Höhe der Vertiefung entspricht.

Wie schon oben erwähnt, werden mehrere Rückenplatten der genannten Art nebeneinander, die jeweils mit Kacheln versehen sind, auf einer Trägerplatte befestigt, um ein größeres Sputtertarget mit einer entsprechend ausgedehnten Kühlfläche zu erhalten. Da jede einzelne, einen Abschnitt des Sputtertargets bildende Rückenplatte über einen eigenen Kühlkreislauf verfügt, kann eine effektive Kühlung erzielt werden. Um die Montage zu vereinfachen, sind die Stirnseiten der aneinander stoßenden Trägerplatten mit korrespondierenden Absätzen versehen. Die Kacheln schließen jeweils bündig mit der Stirnseite der Rückenplatte ab, auf der sie befestigt sind, so dass die Kacheln auf zwei benachbart montierten Rückenplatten stumpf aneinanderstoßen.

Da das Sputtertarget in mehrere Teilstücke gegliedert ist, lassen sich die einzelnen Teilstücke, bestehend jeweils aus einer Rückenplatte und den darauf befestigten Kacheln, relativ leicht voneinander trennen und handhaben, so dass Wartungs- und Reparaturarbeiten sowie das Auswechseln der verbrauchten Kacheln leicht durchgeführt werden können. Die leichte Teilbarkeit wird insbesondere dadurch erreicht, dass jede Rückenplatte einen eigenen Kühlkreislauf besitzt und damit die Kühlkanäle in der Rückenplatte zumindest nicht innerhalb des Kessels miteinander kommunizieren. Dies hat darüber hinaus den Vorteil, dass keine Verbindungen der Kühlkanäle der Rückenplatte untereinander realisiert werden müssen. Solche Verbindungen lassen sich unter den gegebenen Betriebsbedingungen in einem Kessel bei Sputtern nur mit großem Aufwand dicht halten. Durch den modularen Aufbau lassen sich somit große, wirtschaftlich zu betreibende Sputtertargets realisieren.

Zur Verdeutlichung des Erfindungsgedankens wird im Folgenden dieser anhand eines Ausführungsbeispiels dargestellt und in mehreren Figuren näher erläutert. Dazu zeigen:
- Fig. 1: eine perspektivische Explosionsdarstellung eines Ensembles von mehreren Rückenplatten mit Blick auf die Rückseite der Rückenplatten,
- Fig. 2: einen Querschnitt durch eine Rückenplatte in ihrem Endbereich,
- Fig. 3: einen Querschnitt durch zwei Rückenplatten an ihren anstoßenden Stirnflächen, und
- Fig. 4: eine perspektivische Darstellung eines Ensembles von mehreren Rückenplatten mit Blick auf die Vorderseite der Rückenplatten
- Fig. 5: einen Querschnitt durch einen Kühlmittelanschluss.

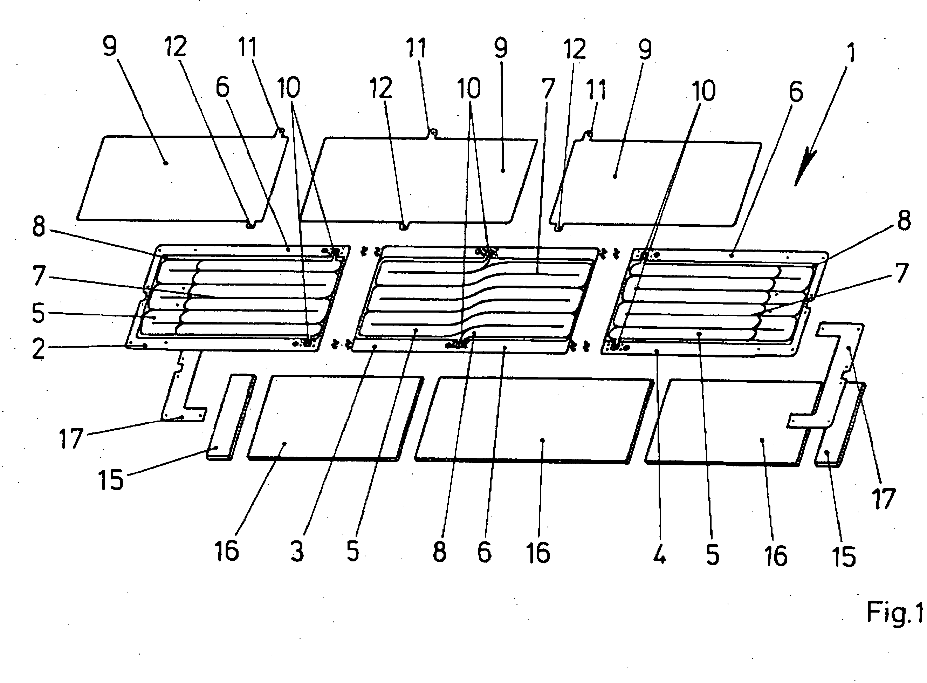

Die Figur 1 zeigt ein Sputtertarget 1, bestehend aus mehreren, nebeneinander gesetzten Rückenplatten 2, 3, 4. Die Rückenplatten 2, 3, 4 haben jeweils eine rechteckige Form und stoßen mit ihren kurzen Stirnseiten aneinander, so dass zwei äußere Rückenplatten 2, 4 an den Enden des Sputtertargets 1 und eine mittlere Rückenplatte 3 in der Mitte angeordnet ist. Das Sputtertarget 1 kann beliebig verlängert werden, indem weitere Rückenplatten, die der mittleren Rückenplatte 3 entsprechen, zwischen den beiden äußeren Rückenplatten 2, 4 gesetzt werden. Grundsätzlich können die Rückenplatten auch breiter als hier dargestellt ausgeführt werden, wobei die aneinanderstoßenden Stirnseiten von den dann langen Seiten der Rückenplatten gebildet werden.

Die Figur 1 zeigt die Sicht von unten, also auf die Rückseite der Rückenplatten 2, 3, 4. In der Rückseite jeder Rückenplatte ist eine mäandernde Nut 5 eingefräst, so dass die Nut 5 insgesamt von einem Rahmen 6 umschlossen ist. Um die einzelnen Abschnitte der mäandernden Nut 5 voneinander zu trennen, sind Stege 7 ausgebildet, die sich abwechselnd von der einen bzw. anderen Stirnseite über die Länge der Rückenplatte erstrecken. Die innere Seite des Rahmens ist mit einem Absatz 8 versehen, der auf gleicher Höhe mit der Oberkante der Stege 7 verläuft. Zum Verschließen der Nut 5 und damit zur Bildung eines Kühlkanals kann eine Verschlussplatine 9 in den Rahmen eingelegt werden, wobei die Dicke der Verschlussplatine 9 der Höhe des Absatzes 8 entspricht, wobei sich ein bündiger Abschluss mit dem Rahmen 6 ergibt.

Um die Zufuhr und den Abfluss des Kühlwassers zu realisieren, befinden sich in den gegenüberliegenden Längsabschnitten des Rahmens 6 je eine in die Nut 5 mündende Tasche 10, die von seitlich abstehenden Ohren 11 an der Verschlussplatine 9 überdeckt werden, wobei sich in den Ohren 11 jeweils ein Loch 12 befindet, das über der Tasche 10 liegt.

Auf der hier nicht zu erkennenden Vorderseite der Rückenplatten 2, 3, 4 werden Kacheln 15, 16 aufgelötet, die aus dem zu sputternden Material bestehen. Sind diese verbraucht, können die Reste abgelöst und durch neue Kacheln 15, 16 ersetzt werden.

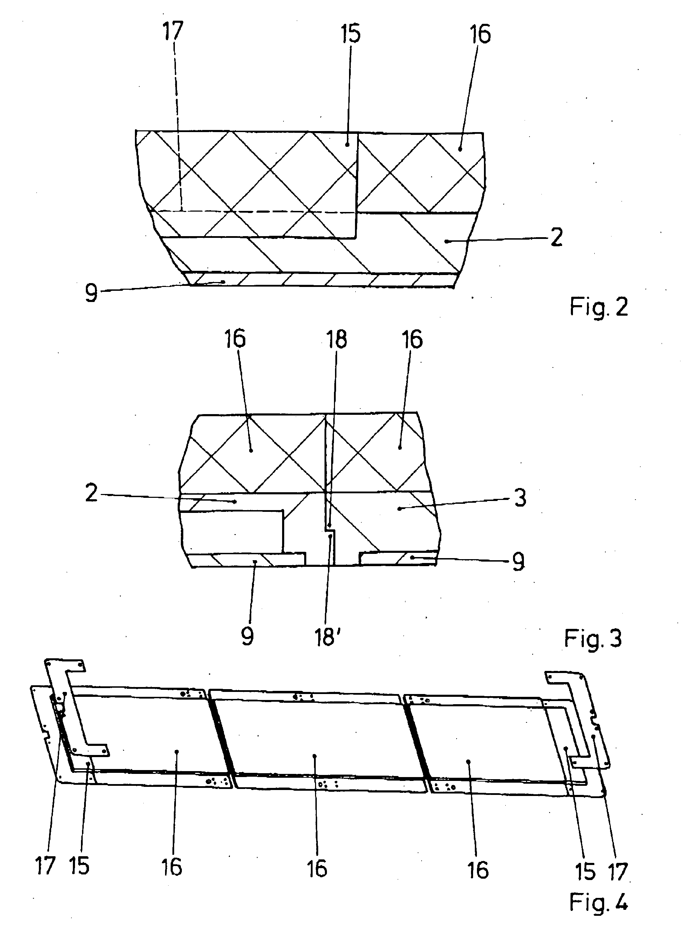

Wie der Figur 4 zu entnehmen ist, erstrecken sich die Kacheln 15, 16 für die mittlere Rückenplatte 3 über deren gesamte Länge, lassen aber in der Breite den Rand frei. Die außen liegenden Enden der äußeren Rückenplatten 2, 4 sind, was auch dem Querschnitt der Figur 2 zu entnehmen ist, stufig nach unten abgesetzt, so dass dort dickere Kacheln 15 aufgesetzt werden, die bündig mit der anschließenden flacheren Kachel 16 abschließen. Um dies zu erreichen, ist die Rückseite der äußeren Rückenplatten 2, 4 in ihrem Endabschnitt über die gesamte Breite flächig abgesetzt. Die Ausnutzung der gesamten Breite erleichtert das Anlöten der dickeren Kacheln 15, da der untere Rand der Kacheln frei liegt. Um nach der Befestigung der Kacheln 15, 16 einen bündigen Anschluss des frei gebliebenen Randes an dem übrigen Randbereich zu erhalten, wird ein U-förmiges Füllblech 17 auf der Vorderseite der Rückenplatte 2, 3, 4 befestigt, das die dickere Kachel 15 an drei Seiten einschließt. Die Lage des Füllbleches 17 ist in der Figur 2 strichpunktiert angedeutet.

Die Figur 3 zeigt den Übergang zwischen zwei Rückenplatten, z. B. einer äußeren Rückenplatte 2 und der mittleren Rückenplatte 3. Um hier die Montage zu vereinfachen, ist jede Stirnseite mit einem Absatz 18, 18' versehen, die korrespondierend ausgebildet sind, wobei ein Vorsprung an der einen Platte 2 in eine Vertiefung an der anderen Rückenplatte 4 eingreift.

Die eingelegten Verschlussplatinen 9 werden mit einem Elektronenstrahl-Schweißverfahren sowohl umlaufend mit dem Absatz 8 des Randes 6 verschweißt, so dass der Nutbereich insgesamt gedichtet ist, was zur Bildung eines gedichteten Kühlkanalbereichs zunächst ausreichend wäre. Zusätzlich erfolgt eine Verschweißung mit einem oder mehreren Stegen 7. Diese Verschweißung dient insbesondere der Versteifung der Anordnung, so dass trotz der relativ dünn ausgeführten Rückenplatte 2, 3, 4 eine hohe Verwindungssteife der Rückenplatte 2, 3, 4 erzielt wird . Die Verschweißung kann mit allen Stegen 7 erfolgen. Sie kann auch nur mit einem der mittleren Stege 7 erfolgen.

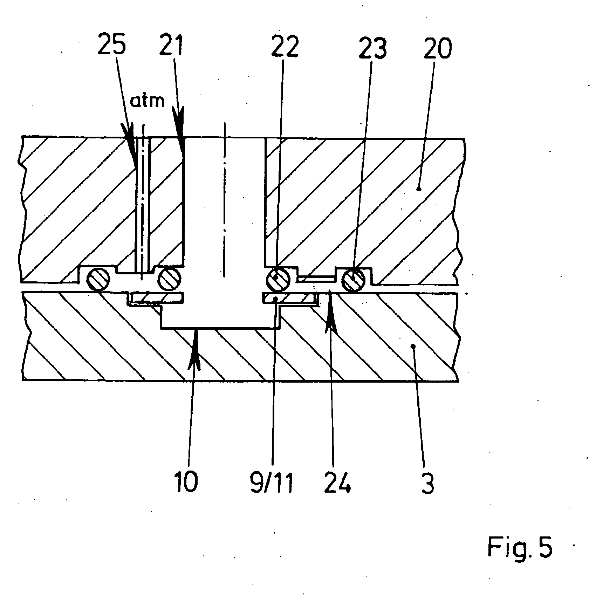

Die Figur 5 zeigt die Verbindung einer derartigen Rückenplatte mit einer Trägerplatte 20, die mit Kühlwasserbohrungen 21 versehen ist, von denen eine dargestellt ist. Diese fluchtet mit einem der Löcher 12 in einer der Verschlussplatinen 9. Zum Abdichten der Verbindung ist eine doppelte Dichtanordnung vorgesehen, die aus einem ersten, innen liegenden Dichtungsring 22 und einem zweiten, radial außen liegenden Dichtungsring 23 besteht. Zwischen diesen ist ein Ringraum 24 ausgebildet, der über eine Lüftungsbohrung 25 mit der Außenseite der Trägerplatte 20 in Verbindung steht, also den Ringraum 24 mit der Atmosphäre verbindet. Die Dichtungsringe 22, 23 liegen in Nuten an der Innenseite der Trägerplatte 20; auch der Ringraum 24 ist dort ausgebildet. Die innere Ringdichtung bewirkt eine Abdichtung der Kühlmittelflüssigkeit gegenüber der Atmosphäre, der äußere Dichtungsring 23 eine Abdichtung des Ringraumes, also der Atmosphäre gegenüber dem Vakuum, das an der Innenseite der Trägerplatte 20 im Kessel herrscht.

### Bezugszeichenliste

- 1: Sputtertarget
- 2: äußere Rückenplatte
- 3: mittlere Rückenplatte
- 4: äußere Rückenplatte
- 5: Nut

- 6: Rahmen
- 7: Steg
- 8: Absatz
- 9: Verschlussplatine
- 10: Tasche

- 11: Ohr
- 12: Loch

- 15: dickere Kachel

- 16: dünnere Kachel
- 17: Füllblech
- 18, 18': Absatz

- 20: Trägerplatte
- 21: Kühlmittelbohrung
- 22: Dichtungsring
- 23: Dichtungsring
- 24: Ringraum

- 25: Lüftungsbohrung

## Patentansprüche

1. Trägerplatte mit einer darauf aufgesetzten gekühlten Rückenplatte (2, 3, 4) für ein Sputtertarget, auf deren Vorderseite ein zu sputterndes Material anbringbar ist und auf deren Rückseite Mittel zur Kühlung der Rückenplatte vorhanden sind, die aus einem zwischen einem Kühlmitteleinlass und einem Kühlmittelauslass verlaufenden Kühlkanal bestehen, wobei die Trägerplatte (20) mit den Kühlmittelein- und auslässen fluchtende Kühlmittelbohrungen (21) aufweist und die Übergänge zwischen den Kühlmittelbohrungen 21 und den Kühlmittelein- und -auslässen gedichtet sind, **dadurch gekennzeichnet, dass** jede Dichtung aus radial beabstandeten Dichtungsringen (22, 23) besteht, zwischen denen ein Ringraum (24) ausgebildet ist, der über eine Lüftungsbohrung (25) mit der von der Rückenplatte (2, 3, 4) abgewandten Seite der Trägerplatte (20) in Verbindung steht.

2. Trägerplatte nach Anspruch 1, **dadurch gekennzeichnet, dass** die Dichtungsringe (22, 23) in der der Rückenplatte (2, 3, 4) zugewandten Seite der Trägerplatte (20) angeordnet sind.

3. Trägerplatte nach Anspruch 1 oder 2, **dadurch gekennzeichnet, dass** in der Rückenplatte (2, 3, 4) wenigstens eine zur Rückseite der Rückenplatte offene Nut (5) zwischen einem Kühlmitteleinlass und einem Kühlmittelauslass verläuft, dass die Nut (5) von einem äußeren Rahmen (6) der Rückenplatte (2, 3, 4) umgeben ist und innerhalb des Rahmens (6) wenigstens ein vom Rahmen entfernter Steg (7) verläuft, der zwei Nutabschnitte voneinander trennt, und dass die offene Seite der Nut (5) zur Bildung eines im Querschnitt geschlossenen Kühlkanals durch eine Verschlussplatine (9) verschlossen ist, die mit dem Rahmen (6) und dem Steg (7) verschweißt ist und in der Löcher vorhanden sind, die den Kühlmitteleinlass und den Kühlmittelauslass bilden.

4. Trägerplatte nach Anspruch 3, **dadurch gekennzeichnet, dass** der Innenrand des Rahmens (6) mit einem umlaufenden Absatz (8) zur Aufnahme der Verschlussplatine (9) versehen ist, dessen Höhe der Dicke der Verschlussplatine (9) entspricht, so dass die auf dem Absatz (8) aufliegende Verschlussplatine (9) bündig mit dem nicht abgesetzten Teil des Rahmens (6) abschließt.

5. Trägerplatte nach Anspruch 3 oder 4, **dadurch gekennzeichnet, dass** im Rahmen (6) wenigstens zwei zur Rückseite hin offene Taschen (10) vorhanden sind, die von der Verschlussplatine (9) überdeckt sind, wobei in der Verschlussplatine (9) über den Taschen liegende Löcher (12) vorhanden sind, die den Kühlmitteleinlass und den Kühlmittelauslass zum Ein- bzw. Austritt eines Kühlmittels bilden.

6. Trägerplatte nach Anspruch 5, **dadurch gekennzeichnet, dass** die Taschen (10) im nicht abgesetzten Teil des Rahmens (8) ausgebildet sind und die Verschlussplatine (9) Ohren (11) aufweist, die über den Taschen (10) liegen und in denen die Löcher (12) zum Ein- bzw. Austritt eines Kühlmittels vorhanden sind.

7. Trägerplatte nach einem der vorhergehenden Ansprüche, **dadurch gekennzeichnet, dass** die Rückenplatte (2, 3, 4) eine rechteckige Form hat und die Vorderseite der Rückenplatte an einem Randbereich über,die gesamte Breite gegenüber ihrem Hauptteil vertieft abgesetzt ist.

8. Trägerplatte nach Anspruch 7, **dadurch gekennzeichnet, dass** auf dem Rand des vertieften Bereichs ein U-förmiges Füllblech (17) angesetzt ist, dessen Dicke der Höhe der Vertiefung entspricht.

## Claims

1. Carrier plate with a cooled backing plate (2, 3, 4) placed thereon for a sputter target, on the front side of which a material to be sputtered can be disposed and on the back side of which means for cooling the backing plate are provided, which means are comprised of a cooling channel extending between a cooling means inlet and a cooling means outlet, wherein the carrier plate (20) includes cooling means bores (21) aligned with the cooling means inlets and outlets and the transitions between the cooling means bores 21 and the cooling means inlets and outlets are sealed, **characterized in that** each seal is comprised of O-rings (22, 23) radially spaced apart, between which an annular volume (24) is formed which, via a venting bore (25), is connected with the side of the carrier plate (20) facing away from the backing plate (2, 3, 4).

2. Carrier plate as claimed in claim 1, **characterized in that** the O-rings (22, 23) are disposed in the side of the carrier plate (20) facing the backing plate (2, 3, 4).

3. Carrier plate as claimed in claim 1 or 2, **characterized in that** in the backing plate (2, 3, 4) at least one groove (5), open toward the back side of the backing plate, extends between a cooling means inlet and a cooling means outlet, that the groove (5) is encompassed by an outer frame (6) of the backing plate (2, 3, 4) and within the frame (6) extends at least one web (7) remote from the frame, which web separates two groove sections from one another, and that the open side of the groove (5) for the formation of a cooling channel with closed cross section, is closed by a closure board (9) which is welded to the frame (6) and the web (7) and in which holes are provided forming the cooling means inlet and the cooling means outlet.

4. Carrier plate as claimed in claim 3, **characterized in that** the inner margin of the frame (6) is provided with an encompassing shoulder (8) for receiving the closure board (9), the height of which corresponds to the thickness of the closure board (9) such that the closure board (9) resting on the shoulder (8) closes flush with the non-offset portion of the frame (6).

5. Carrier plate as claimed in claim 3 or 4, **characterized in that** in the frame (6) at least two pockets (10) open toward the back side are provided, which are covered by the closure board (9), wherein in the closure board (9) holes (12) located above the pockets are provided, which form the cooling means inlet and the cooling means outlet for the admittance or exit of a cooling means.

6. Carrier plate as claimed in claim 5, **characterized in that** the pockets (10) are formed in the non-offset portion of the frame (8) and the closure board (9) includes ears (11) which are located above the pockets (10) and in which the holes (12) are provided for the admittance or exit of a cooling means.

7. Carrier plate as claimed in claim 6, **characterized in that** the backing plate (2, 3, 4) has a rectangular form and the front side of the backing plate is offset with a recess, compared to the main portion, over the entire width on a margin region.

8. Carrier plate as claimed in claim 7, **characterized in that** on the margin of the recessed region a U-shaped metal filler sheet (17) is applied, whose thickness corresponds to the height of the recess.

## Revendications

1. Plaque de support pour cible de pulvérisation cathodique pourvue d'une plaque arrière (2, 3, 4) refroidie, montée sur celle-ci, sur la face avant de laquelle peut être placée une matière devant être déposée par pulvérisation cathodique et sur la face arrière de laquelle sont prévus des moyens destinés au refroidissement de la plaque arrière lesquels se composent d'un canal de refroidissement s'étendant entre une entrée d'agent de refroidissement et une sortie d'agent de refroidissement, la plaque de support (20) présentant des alésages d'agent de refroidissement (21) en alignement avec les entrées et sorties d'agent de refroidissement, et les transitions entre les alésages d'agent de refroidissement (21) et les entrées et sorties d'agent de refroidissement étant étanchéifiées, **caractérisée en ce que** chaque joint d'étanchéité se compose de bagues d'étanchéité (22, 23) espacées entre elles de manière radiale et entre lesquelles est formé un espace annulaire (24) qui est relié, par un alésage d'aération (25), à la face de la plaque de support (20) opposée à la plaque arrière (2, 3, 4).

2. Plaque de support selon la revendication 1, **caractérisée en ce que** les bagues d'étanchéité (22, 23) sont disposées dans la face de la plaque de support (20) tournée vers la plaque arrière (2, 3, 4).

3. Plaque de support selon la revendication 1 ou 2, **caractérisée en ce qu'**au moins une rainure (5) ouverte vers la face arrière de la plaque arrière s'étend dans la plaque arrière (2, 3, 4) entre une entrée d'agent de refroidissement et une sortie d'agent de refroidissement, **en ce que** la rainure (5) est entourée par un cadre extérieur (6) de la plaque arrière (2, 3, 4), qu'au moins une nervure (7) s'étend à l'intérieur du cadre (6) de manière éloignée du cadre et sépare deux segments de rainure, et **en ce que**, pour.former un canal de refroidissement à section fermée, le côté ouvert de la rainure (5) est fermé par une platine de fermeture (9) qui est soudée au cadre (6) et à la nervure (7) et dans laquelle sont ménagés des trous qui forment l'entrée d'agent de refroidissement et la sortie d'agent de refroidissement.

4. Plaque de support selon la revendication 3, **caractérisée en ce que** le bord intérieur du cadre (6) est pourvu d'un épaulement circonférentiel (8) destiné à recevoir la platine de fermeture (9) et dont la hauteur correspond à l'épaisseur de la platine de fermeture (9) de sorte que la platine de fermeture (9), lorsqu'elle repose sur l'épaulement (8), forme une surface plane avec la partie non décalée du cadre (6).

5. Plaque de support selon la revendication 3 ou 4, **caractérisée en ce que** dans le cadre (6) sont ménagées deux poches (10) ouvertes vers la face arrière, lesquelles sont recouvertes par la platine de fermeture (9), dans la platine de fermeture (9) étant ménagés des trous (12) situés au-dessus des poches, lesquels forment l'entrée d'agent de refroidissement et la sortie d'agent de refroidissement pour permettre l'entrée et la sortie d'un agent de refroidissement.

6. Plaque de support selon la revendication 5, **caractérisée en ce que** les poches (10) sont formées dans la partie non décalée du cadre (8), et **en ce que** la platine de fermeture (9) présente des oreilles (11) qui sont situées au-dessus des poches (10) et dans lesquelles sont ménagés les trous (12) pour permettre l'entrée et la sortie d'un agent de refroidissement.

7. Plaque de support selon l'une quelconque des revendications précédentes, **caractérisée en ce que** la plaque arrière (2, 3, 4) a une forme rectangulaire, et **en ce que** la face avant de la plaque arrière est, sur une partie périphérique, en retrait sur toute la largeur par rapport à sa partie principale.

8. Plaque de support selon la revendication 7, **caractérisée en ce que** sur le bord de la partie en retrait est placée une plaque de remplissage (17) en U dont l'épaisseur correspond à la hauteur du retrait.
